# EUROPEAN PATENT APPLICATION

(11) **EP 3 093 923 A1**
(43) Date of publication of application: **16.11.2016**
(21) Application number: 16155614.7
(22) Date of filing: 15.02.2016
(51) Int. Cl.: H01R 12/57, H01R 13/24, H05K 3/40

(54) **ELASTIC ELECTRIC CONTACT TERMINAL ADAPTED TO SMALL SIZE**

(30) Priority: 15.05.2015 KR 20150068327; 28.05.2015 KR 20150075077
(71) Applicant: Joinset Co., Ltd, Kyeonggi-do 425-866 (KR); Kim, Sun-ki, Gunpo-si, Kyeonggi-do 435-040 (KR)
(72) Inventor: KIM, Sun-Ki, 435-040 Gunpo-si, Kyeonggi-do (KR)
(74) Representative: Kuhnen & Wacker

(57) **Abstract**

Disclosed is an elastic electric contact terminal including an elastic core provided with at least one or more channels which are recessed downwardly from the top surface thereof with a predetermined width and depth and extend in a lengthwise direction, a polymer film surrounding and adhering to the elastic core, and a solderable metal layer surrounding and adhering to the polymer film, wherein both side walls of the channels elastically support an object.

## Description

### BACKGROUND ART

### Field of the Invention

The present invention relates to an elastic electric contact terminal, and more particularly, to an elastic electric contact terminal having a structure adapted to a small size.

### Description of the Related Art

In general, solderable elastic electric contact terminals are required to have superior electric conductivity and resiliency, and to endure the soldering temperature.

As an example of the elastic electric contact terminals, Korean Patent No. 783588 devised by the inventor of the present invention discloses a solderable elastic electric contact terminal characterized by including: an insulating foamed rubber having a predetermined volume; an insulating unfoamed adhesive layer surrounding and adhered to the insulating foamed rubber; and a heat- resistant polymer film adhered to the insulating unfoamed adhesive layer such that one surface thereof surrounds the unfoamed adhesive layer and having the other surface on which a metal layer is integrally formed.

Also, Korean Patent No. 1001354 discloses an elastic electric contact terminal which may be soldered by reflow soldering and is characterized by including: an insulating elastic heat-resistant rubber core having a through hole formed therein in the lengthwise direction thereof; an insulating heat-resistant adhesive layer surrounding and adhered to the insulating elastic heat-resistant rubber core; and a heat-resistant polymer film adhered to the insulating heat-resistant adhesive layer such that one surface thereof surrounds the insulating heat-resistant adhesive layer and having the other surface on which a metal layer is integrally formed, wherein the polymer film is adhered to the insulating heat-resistant adhesive layer such that both ends thereof are spaced apart from each other, and a lower surface of the insulating elastic heat-resistant rubber core is formed in a concave shape inclined toward a central portion from both ends in a widthwise direction thereof.

In case of the electric contact terminal having the above-mentioned structure, a core is allowed to have elasticity by forming a through hole inside the cylindrical core along the lengthwise direction or by manufacturing the core itself as a tubular shape, and consequently the electric contact terminal is enabled to elastically support an object.

However, when the electric contact terminal has a small size with a height of approximately 0.5 mm or less, it is not only difficult to form a through hole but also difficult to fabricate the terminal as a tubular shape, and the efficiency of manufacturing decreases.

Also, a metal plated layer having environment-resistance better than that of copper is formed on a copper foil of a typical electric contact terminal so as to prevent corrosion and to facilitate soldering by using solder cream. However, since the electrical contact terminal is cut into a user's desired length during manufacturing, the copper foil is inevitably exposed to the outside at a cut surface formed in a side surface in the lengthwise direction of the electrical contact terminal.

In other words, since the typical electrical terminal is manufactured in such a way that a core is surrounded by a polymer film which has a copper foil plated with a metal layer such as tin and is then cut, the copper foil, of course, is inevitably exposed to the outside at a cut surface

As a result, in a reliability test such as a brine test, the brine contacts the copper foil exposed to the outside, so that there are problems in that the corrosion due to brine causes a failure in the brine test, or the copper foil exposed to the outside easily becomes rusty to thereby cause quality deterioration.

### Summary of the Invention

An object of the present invention is to provide an elastic electric contact terminal having a structure adapted to a small size with a predetermined height or less.

Another object of the present invention is to provide an elastic electric contact terminal having strong corrosion-resistance.

A further another object of the present invention is to provide an elastic electric contact terminal having improved soldering strength and soldering reliability.

According to an aspect of the present invention, there is provided an elastic electric contact terminal including: an elastic core provided with at least one or more channels which are recessed downwardly from the top surface thereof with a predetermined width and depth and extend in a lengthwise direction of the terminal; a polymer film surrounding and adhering to the elastic core; and a solderable metal layer surrounding and adhering to the polymer film, wherein the polymer film extends across the channels to be placed on both side walls of the channels and both the side walls of the channels elastically support an object.

The channels may be formed in plurality, and the elastic electric contact terminal may further include a support wall protruding between the channels at a height corresponding to both the walls of the channels.

A vertical cross-section of the support wall may have a trapezoidal shape which has a size gradually decreasing towards the upper end thereof.

The channel-side side surfaces of both the side walls may be inclined such that both the side walls are inclined toward the channel side when pressed by the object.

The top surface of the support wall may adhere to the polymer film with the adhesive layer in-between.

The metal layer may include a copper foil and a metal plated layer surrounding a surface and a side surface of the copper foil, and the side surface of the copper foil may include a cut surface in the lengthwise direction and both cross-sectional surfaces in a widthwise direction.

A thickness of the copper foil may be greater than that of the metal plated layer, and the copper foil may be an electrolytic copper foil or rolled copper foil, and may adhere to the polymer film by applying and curing a liquid polymer corresponding to the polymer film thereon, or may adhere to the polymer with an adhesive in-between.

The metal plated layer may be formed by electroless plating to thereby have an increased surface roughness such that soldering strength is improved.

According to another aspect of the present invention, there is provided an elastic electric contact terminal comprising: an elastic core provided with at least one or more channels which are recessed downwardly from the top surface thereof with a predetermined width and depth and extend in a lengthwise direction; an electrically conductive elastic rubber coated layer adhering to an outer surface of the elastic core; and a solderable metal foil adhering to a lower surface of the elastic rubber coated layer, wherein both side walls of the channels elastically support the object.

The electric contact terminal may have the width greater than the length.

The electrical contact terminal may be soldered to a conductive pattern of a circuit board by using solder cream and may thereby electrically connect the facing electrically conductive object to the conductive pattern while maintaining elasticity therebetween.

### Brief Description of the Drawings

The above objects and other advantages of the present invention will become more apparent by describing in detail exemplary embodiments thereof with reference to the attached drawings in which:
FIG. 1 illustrates an electric contact terminal according to an embodiment of the present invention;
FIG. 2A and 2B illustrate an operation of an electrical contact terminal according to an embodiment of the present invention, respectively;
FIG. 3 is illustrates an electric contact terminal according to another embodiment of the present invention, FIG. 3A is a perspective view, and FIG. 3B is a front view; and
FIG. 4 illustrates an electric contact terminal according to another embodiment of the present invention.

### Detailed Description of embodiment

Now, exemplary embodiments of the present invention will be described in detail with reference to the accompanying drawings.

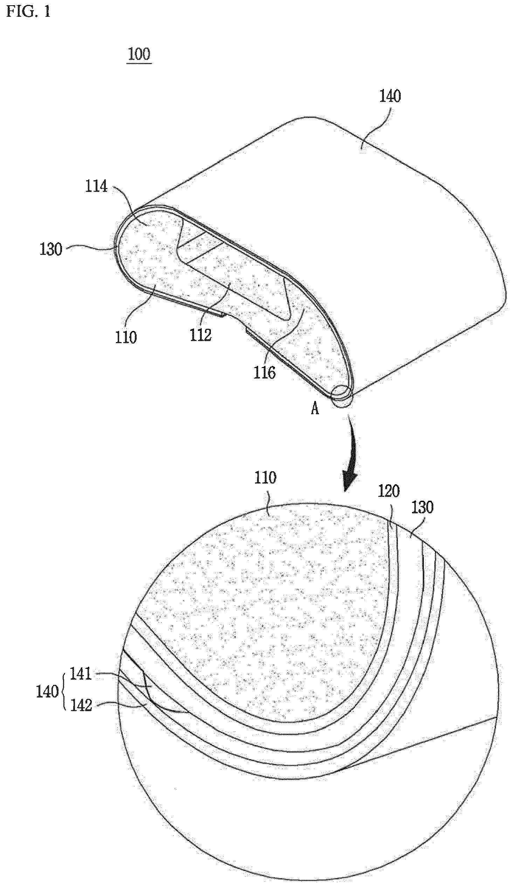

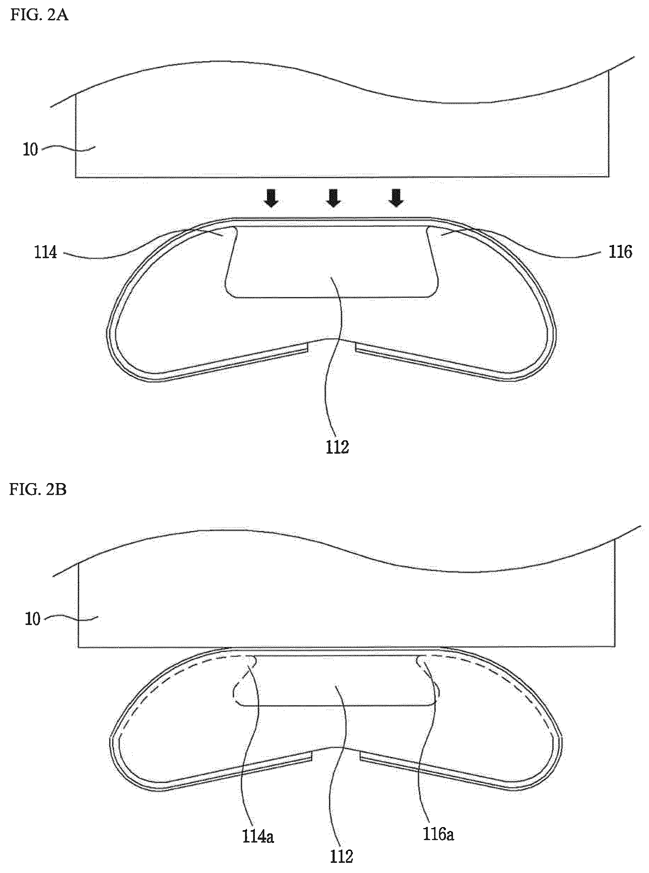

FIG. 1 illustrates an electric contact terminal according to an embodiment of the present invention, and FIG. 2A and 2B illustrate an operation of an electrical contact terminal according to an embodiment of the present invention, respectively.

An electric contact terminal 100 functions to electrically connect a circuit board with an electrically conductive object 10 by being interposed therebetween, for example, is installed by being forcibly inserted between a conductive pattern of the circuit board and the electrically conductive object 10, or is soldered to the conductive pattern of the circuit board through a solder cream. Thus, the electric contact terminal 100 may be enabled to elastically contact the facing electrically conductive object 10.

In case of reflow soldering, the electrical contact terminal 100 is supplied by being attached on a reel-tape in a carrier, and is reflow soldered through vacuum pick up and the solder cream.

Referring to FIG. 1, the electrical contact terminal 100 includes: an elastic core 110 having at least one or more channels 112 which are sufficiently recessed in the downward direction from the top surface thereof and extend in the lengthwise direction; a polymer film 130 surrounding and adhering to the core 110 with an adhesive layer 120 in-between; and a solderable metal layer 140 surrounding and adhering to the polymer film 130.

According to this embodiment, both side walls 114 and 116 of the channel 112 elastically support the object positioned thereon.

Hereinafter, the detailed structure of the electrical contact terminal 100 according to this embodiment will be described in detail.

### 1.1 Core 110

The core 110 of a rubber material has heat-resistance and elasticity, and may also have an electrically insulative property. Consequently, unfoamed silicon resin or foamed resin, such as sponge, which satisfies conditions for reflow soldering and elasticity may be used, but the embodiment of the present invention is not limited thereto.

The core 110 may be manufactured by, for example, an extrusion process, and is formed laterally symmetrical to be horizontally balanced during soldering, so that a lifting or a deflection phenomenon may be reduced in reflow soldering using a solder cream.

The core 110 is formed as a single body, and has a channel 112 which is sufficiently recessed in the downward direction from the top surface thereof, extends in the lengthwise direction, and has a predetermined width and depth. Consequently, side walls 114 and 116 are formed on both sides of the channel 112 to contact and support an object positioned thereon.

The core 110 is formed in a small size, for example, may have a width of approximately 2 mm, a height of approximately 0.5 mm, and a length of approximately 1 mm, but is not limited thereto, and may have sizes corresponding thereto or smaller than the above-mentioned sizes.

As described above, for the core 110 having such sizes, when forming a through hole inside the core 110 or fabricating the core 110 itself in a tubular shape as in the related art, it is difficult to make the height of the core equal to or less than approximately 0.7 mm. However, as in this embodiment, since it is sufficient to form a channel 112 having a predetermined width and depth and extending in the lengthwise direction by forming a downward recess from the top surface, an electric contact terminal having the height of approximately 0.5 mm or less may be easily manufactured.

Both side walls 114 and 116 are formed in shapes outer sides of upper ends of which are rounded when viewed in a cross-section. Accordingly, the completed electric contact terminal 100 is enabled to be easily inwardly pressed when pressed by the facing object after being soldered to a printed circuit board or the like, and an outer object is prevented from interfering with both edges thereof.

Side surfaces of the channel 112 side of both the side walls 114 and 116, that is, the inner side surfaces are formed vertically or formed to be inclined toward the channel 112 side. Especially, as illustrated in FIG. 2B, when formed to be inclined toward the channel 112 side, both the side walls 114 and 116 may be pressed with a reduced force when pressed by the object 10 because the side walls are easily inclined toward the channel 112 side.

The lower surface of the core 110 may be formed in a concave shape which is inclined from both end toward the central portion in the widthwise direction. In other words, when the core 110 is vertically cut, the lower surface of the core 110 may be formed in a concave shape which is inclined from both edges in the widthwise direction toward the central portion such that the lower surface of the core 110 defines hypotenuses of an isosceles triangle. Although the inclination angle is not specifically limited, it is sufficient so long as a space of such a degree that does not affect soldering by receiving adhesives leaking from the adhesive layer 120 under the lower surface of the core 110 is provided.

According to this structure, since the lower surface of the core 110 has a concave shape formed inclined from both ends toward the central portion thereof, both sides of the lower surface of the electrical contact terminal 100 uniformly contacts a molten solder during reflow soldering, so that the lifting phenomenon in which only any one side of the lower surface is soldered may be prevented. Also, since the lower surface of the core 110 has a concave shape formed inclined from both ends toward the central portion, a space which may receive adhesives leaking to the outside from the adhesive layer 120 during manufacturing process, so that the phenomenon in which soldering fails during reflow soldering may be minimized.

### 1.2 Adhesive layer 120

The adhesive layer 120 has flexibility, elasticity, and an insulative property, may have heat-resistance when the electrical contact terminal 100 is applied to reflow soldering, and is positioned between the core 110 and the polymer film 130, thereby reliably attaching the core 110 and the polymer film 130 to each other.

The adhesive layer 120 may be formed, for example, by heat curing of liquid silicone rubber. The liquid silicone rubber is adhered to the facing object while cured, and forms a solid adhesive layer 120 after curing. Once cured, the liquid silicone rubber maintains elasticity, and is not melt but maintains the adhesiveness even though heated again, so that the adhesiveness is maintained also during soldering.

The adhesive layer 120 may be formed in such a way that a self-adherent silicone rubber adhesive is cured to have the thickness of approximately 0.005 mm to approximately 0.03 mm.

### 1.3 Polymer film 130

The polymer film 130 may be, for example, a polyimide (PI) film with good heat resistance or other heat-resistant polymer film, and the thickness thereof may be determined in consideration of flexibility and mechanical strength.

The polymer film 130 is, in general, a polymer film used for a flexible circuit board.

For example, the polymer film 130 may be formed in such a way that a liquid polymer is casted and is then cured, and the thickness of the cured polymer film 130 is approximately 0.007 mm to approximately 0.030 mm.

### 1.4 Metal layer 140

The metal layer 140 is formed in such a way that one surface thereof surrounds and adheres to the polymer film 130, for example, a metal plated layer 142 is formed by plating on a copper layer 141, and the metal plated layer 142 is more electrically conductive and more easily soldered than the copper layer 141.

According to this embodiment, the metal plated layer 142 is formed on all exposed surfaces of the copper layer 141, the exposed surfaces including outer surfaces of the copper layer 141, that is, surfaces and side surfaces.

Referring to FIG. 1, the surfaces of the copper layer 141 means outer surfaces identified with the naked eye from the outside, and the side surfaces mean a cut surface in the lengthwise direction and both cross-sectional surfaces in the widthwise direction.

Here, the copper layer 141 is a copper foil of an electrolytic copper foil or a rolled copper foil, or generally refers to a copper plated layer formed on tungsten after the tungsten is sputtered as a seed on one surface of the polymer film. Hereinafter, for convenience of description, the copper foil will be exemplarily described.

The thickness of the copper foil 141 is approximately 10 µm, and the thickness of the copper plated layer is thinly formed to be approximately 3 µm.

It is necessary to note that the metal plated layer 142 has corrosiveness smaller than the copper foil 141, and the thickness of the copper foil 141 is greater than that of the metal plated layer 142.

To allow the metal layer 140 to surround and adhere to the polymer film 130, the copper foil 141 may be attached on the polymer film 130 through adhesives or a liquid polymer corresponding to the polymer film 130 may be applied on the copper foil 141 to be thereby attached by curing.

The metal plated layer 142 is formed by plating tin (Sn) or silver (Ag), or by plating tin (Sn) or gold (Au) after plating nickel (Ni). In case of tin or silver, the thickness may be approximately 2 µm and in case of nickel/gold, the thickness may be approximately 1 µm or less.

Accordingly, the copper foil 141 is prevented from being corroded by laminating the metal layer 140 including a metal plated layer on the polymer film 130 in a material level so that the electric contact terminal 100 may be more electrically conductive and more easily soldered.

Also, since the copper foil 141 is directly exposed to the outside at a cut surface formed by a cut during manufacturing the electrical contact terminal 100, it is necessary to prevent this from corrosion.

For this, as illustrated enlarged in a circle in FIG. 1, the metal plated layer 142 is formed on the exposed copper foil 141 at the cut surface of the electric contact terminal 100, and covers the copper foil 141. That is, referring to FIG. 1, the border between the copper foil 141 and the metal plated layer 142 is expressed by a dotted line, and it may be understood that the copper foil 141 is covered by the metal plated layer 142.

In the related arts, the copper foil is exposed to the outside at a cut surface formed by a cut, and brine contacts the exposed copper foil in a reliability test such as a brine test, thereby causing corrosion. Hence, the brine test is failed or the copper foil is corroded in use, thereby decreasing reliability.

However, according to the present invention, the copper foil 141 exposed at the cut surface is covered by the metal plated layer 142, and thus brine may be basically prevented from contacting the copper foil 141, and since the copper foil is not exposed even in use, there is no concern about corrosion and therefore reliability is increased.

Further, during reflow soldering, a solder cream may be more easily spread on the metal plated layer 142 formed to cover the copper foil 141 at the cut surface, and thus soldering strength is definitely increased and especially increased at the cut surface.

Especially, when the electric contact terminal 100 has the width greater than the length thereof, the soldering strength of the cut surface is very important, and the present invention is very useful in this case.

To manufacture the electric contact terminal 100 according to this embodiment, a contact terminal bar which includes the polymer film 130 and the copper foil 141 attached on one surface of the polymer film 130 with the liquid adhesive layer 120 in-between and is supplied while continuously surrounding the core 110 is cut by a predetermined length. For example, the contact terminal bar may have a length of approximately 500 mm.

Subsequently, the contact terminal bar is cut by a user-desired length, for example, cut in approximately 3 mm to form the contact terminal, and as described above, the metal plated layer 142 plated with tin, silver, or nickel/gold is then formed so as to cover the exposed surface of the copper foil 141 of the contact terminal. Then, the contact terminal 100 is finally manufactured.

Here, the specific weight of the contact terminal 100 is smaller than that of water due to the core 110 of the silicone rubber material. Accordingly, the metal plated layer 142 may be formed by using bulk type electroless plating, but the present invention is not limited thereto, and electroplating may be applied.

Especially, when the metal plated layer 142 is formed by the electroless plating, the surface roughness of the metal plated layer 142 is increased, the surface becomes rough, and as a result, adhesiveness to the solder cream is increased and thus the soldering strength is increased.

As described above, the core 110 is formed of unfoamed silicone rubber, foamed rubber, for example, sponge, the adhesive layer 120 is formed of heat-cured liquid silicone rubber, the polymer film 130 is formed of polyimide film, and thus the metal plated layer 142 is not formed by a plating process at the cut surface.

As described above, in the electric contact terminal 100, the metal plated layer 142 is formed on all the copper foil exposed to the outside including the surface, the cut surface in the lengthwise direction, and both cross-sectional surfaces in the widthwise direction, and thus the copper foil 141 is shielded from the outside.

Referring to FIG. 2B, when the object 10 presses the electrical contact terminal 100, both side walls 114 and 116 contacts the object 10 and is inwardly displaced while being pressed. FIG. 2B illustrates the displaced both the side walls 114a and 116a by a dotted line for distinguishment.

Here, as described above, side surfaces of both the side walls 114 and 116 in the channel 112 side, that is, the inner side surfaces are inclined toward the channel 112 side, and both side walls 114 and 116 may be easily pressed when pressed by the object 10, and thus the force pressing the object may be decreased.

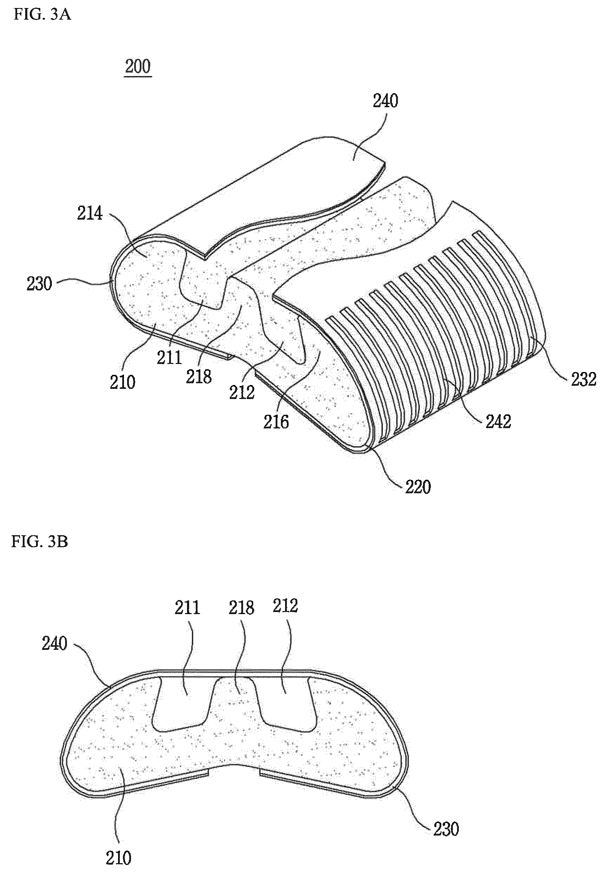

FIG. 3 is illustrates an electric contact terminal according to another embodiment of the present invention, FIG. 3A is a perspective view, and FIG. 3B is a front view.

In an elastic core 210 of an electric contact terminal 200, a pair of channels 211 and 212 which are recessed downwardly from the top surface, has a predetermined width and depth, and extends in the lengthwise direction are provided, and a support wall 218 is formed between the channels 211 and 212.

As in the previous embodiment, a polymer film 230 surrounds and adheres to a core 210 with an adhesive layer 230 in-between, and a solderable metal layer 240 surrounds and adheres to the polymer film 230.

According to this embodiment, both the side walls 214 and 216 of the channels 211 and 212 and the support wall 218 elastically support the object positioned thereon.

In comparison with the embodiment of FIG. 1, the configurations of the core 210 and the metal layer 240 are different, and thus only this will be described.

The core 210 is formed in a single body, a pair of channels 211 and 212 which are recessed downwardly from the top surface thereof and has a predetermined width and depth are formed to be spaced from each other and extends in the lengthwise direction, and as a result, the support wall 218 is formed to have approximately the same height as the side walls 214 and 216 between the channels 211 and 212.

Referring to FIG. 3B, the bottoms of the channels 211 and 212 may be inclined as the lower surface of the core 210 and formed to be upwardly inclined gradually from the bottom outer edges toward the inside thereof.

According to the above-mentioned structure, the side walls 214 and 216 are respectively formed in the outer sides of the channels 211 and 212, the support wall 218 is formed in the inner side of the channels 211 and 212, and the object 10 which is upwardly pressed are supported by the side walls 214 and 216 and the support wall 218.

The upper surface of the support wall 218, like other portions of the core 210, adheres to the polymer film through the adhesive layer 220, and thus may prevent the polymer film 230 from being lifted.

The cross-sectional shape of the support wall 218 is not particularly limited, but may be, for example, a shape which has size gradually decreased toward the top surface, and both upper end edges may be formed round.

As the above-mentioned embodiment, both the side walls 214 and 216 are formed in shapes outer sides of upper ends of which are rounded when viewed in a cross-section. Accordingly, the completed electric contact terminal 200 is enabled to be easily inwardly pressed when being pressed by the facing object after being soldered to a printed circuit board or the like, and an outer object is prevented from interfering with both edges thereof.

According to this embodiment, since the support wall 218 formed between a pair of channels 211 and 212 supports the polymer film 230 passing thereon, no mark due to an object 10 remains on the channels 211 and 212 even though being pressed by the object 10.

Also, although it is exemplified that a pair of channels 211 and 212 are formed, a plurality of channels may be formed, and in this case, a plurality of support walls 218 may be of course formed.

On both side surfaces of the metal layer 240, openings 242 which are formed at predetermined intervals in the lengthwise direction and extend in the height direction are formed, and thus the polymer film 230 may be exposed through the openings 242.

Here, the side surface means the region from a lower end partially including a portion to be soldered to an upper end except for a portion of the upper surface to be picked up by vacuum.

The openings 242 may be formed by removing, for example, corresponding portions of the metal layer by etching, and the width, the length, or he spaced distance may be appropriately adjusted. Especially, the openings 242 are formed symmetrically on both side surfaces, so that soldering strengths of the left and right sides during soldering may be allowed to be the same.

When lower ends of the openings overlap the portion covered by solder during soldering, since the molten solder contacts the polymer film which is not soldered through the openings 242 at the overlapping portion, lead rising may be prevented. In other words, when the electric contact terminal 200 is soldered to a circuit board, the phenomenon in which molten solder rises along the side surface of the metal layer 240 may be minimized by the openings 242.

As described above the lead rising is prevented from occurring, the molten solder may not rise along the metal layer 240, and thus the resiliency of the electric contact terminal may be prevented from decreasing.

Also, in the electric contact terminal having a low height of approximately 0.5 mm or less, since pressing force are much affected by the height of lead rising, the force pressing the electric contact terminal may be much decreased by minimizing the lead rising.

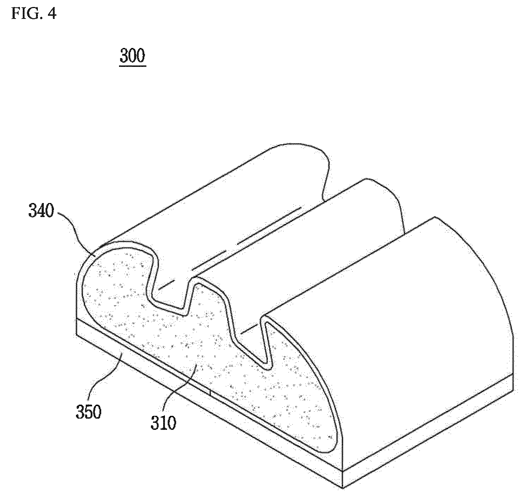

FIG. 4 illustrates an electric contact terminal according to another embodiment of the present invention.

An electric contact terminal 300 includes an elastic core 310, an electrically conductive elastic rubber coated layer 340 surrounding the elastic core 310, and a metal foil 350 attached to a lower surface of the elastic rubber coated layer 340.

The elastic rubber coated layer 340 may be formed in such a way that a material in which for example, metal powder of approximately 50 µm or less are uniformly mixed to liquid elastic rubber is applied at the same thickness to the outside of the elastic core 310 through a mold, and is then cured.

The elastic rubber coated layer 340 may have the hardness of approximately 40 in Shore A to approximately 70 in Shore A, the electrical resistance is approximately 1 Ω or less, and the coating thickness may be approximately 10 µm to approximately 40 µm.

The metal foil 350 may be approximately 8 µm to approximately 200 µm or less, copper may be used as a metal material, and gold or tin is further applied if necessary, thereby preventing corrosion or facilitating soldering.

The elastic core 310 is continuously manufactured by extrusion and curing processes, and is cured while a material, in which metal powder is mixed to electrically conductive elastic liquid rubber, is applied to the outer surface of the elastic core 310 and a copper foil 350 is supplied on the lower surface in the lengthwise direction.

The elastic rubber coated layer 340 is formed while the electrically conductive elastic liquid rubber is cured, and at the same time, the elastic rubber coated layer 340 and the copper foil 350 are mechanically and electrically jointed.

Like the above-mentioned embodiment, in the small-sized electric contact terminal having the height of approximately 0.5 mm or less which is difficult to form a through hole inside the core and to fabricate in a tubular shape, at least one or more channels having a predetermined width and depth in the lengthwise direction from the top surface of the core to the bottom are formed, and thus the object may be elastically supported by using side walls of both sides of the channels or a support wall formed between the channels.

In the above-mentioned embodiments, the case in which the electric contact terminals 100, 200, and 300 contact the facing electrically conductive object by being soldered to the conductive pattern of a circuit board by using a solder cream, is exemplarily described, but the present invention is not limited thereto, and as described above, the electric contact terminals may be installed by being forcibly inserted between the conductive pattern of a circuit board and the electrically conductive object. In this case, since there is no process like reflow soldering, materials of components do not necessarily have heat resistance.

As described above, an electric contact terminal with a small size approximately 0.5 mm or less is provided with at least one or more channels which are downwardly formed from the top surface of the core and have predetermined widths and depths, and thus an object may be supported by using a side walls of both sides of the channels or a support wall between the channels.

As a result, the electric contact terminal with a size difficult to form a through hole inside the core or to manufacture the core itself as a tubular shape, as in the related art, may be easily and efficiently manufactured.

Also, a copper foil exposed on a cut surface in the lengthwise direction is covered with a metal plated layer having a good anti-environment property, and thus brine may be basically prevented from contacting the copper foil in a reliability test, and also in use, the copper foil is not exposed to the outside, and thus reliability is improved because there is no concern about corrosion.

Also, solder cream is easily spread on the metal plated layer formed to cover the copper foil at the cut surface in the lengthwise direction, and thus the soldering strength is increased.

According to the above-mentioned structure, an electric contact terminal with a size difficult to form a through hole inside a core or to fabricate the core itself in a tubular shape, as in the related art, may be easily and efficiently manufactured.

Also, a copper foil exposed on a cut surface in the lengthwise direction is covered with a metal plated layer having a good anti-environment property, and thus brine may be basically prevented from contacting the copper foil in a reliability test, and also in use, the copper foil is not exposed to the outside, and thus reliability is improved because there is no concern about corrosion.

Also, solder cream is easily spread on the metal plated layer formed to cove the copper foil at the cut surface in the lengthwise direction, and thus the soldering strength is increased at the cut surface.

While the embodiment of the present invention has been mainly described, various changes and modifications can be made hereto by the person skilled in the art.

It should be understood that these changes and modifications are included in the scope of the present invention unless departing from the spirit and scope of the invention. The protective scope of the present invention shall be determined by the technical scope of the accompanying Claims.

## Claims

1. An elastic electric contact terminal interposed between objects and contacting the objects to form an electric passage between the objects, the elastic electric contact terminal comprising:
an elastic core provided with at least one or more channels which are recessed downwardly from the top surface thereof with a predetermined width and depth and extend in a lengthwise direction;
a polymer film surrounding the elastic core with an adhesive layer in-between; and
a solderable metal layer surrounding and adhering to the polymer film,
wherein the polymer film extends across the channels to be placed on both side walls of the channels, and both the side walls of the channels elastically support the object.

2. The elastic electric contact terminal of claim 1, wherein the channels are formed in plurality, and a support wall protruding between the channels at a height corresponding to both the side walls and extending in the lengthwise direction is further included.

3. The elastic electric contact terminal of claim 2, wherein a vertical cross-section of the support wall has a trapezoidal shape which has a size gradually decreasing towards the upper end thereof.

4. The elastic electric contact terminal of claim 1, wherein channel-side side surfaces of both the side walls are inclined such that both the side walls are inclined toward the channel side when pressed by the objects.

5. The elastic electric contact terminal of claim 2, wherein the top surface of the support wall adheres to the polymer film with the adhesive layer in-between.

6. The elastic electric contact terminal of claim 1, wherein the metal layer comprises a copper foil and a metal plated layer surrounding a surface and a side surface of the copper foil, and the side surface of the copper foil comprises a cut surface in the lengthwise direction and both cross-sectional surfaces in a widthwise direction.

7. The elastic electric contact terminal of claim 6, wherein a thickness of the copper foil is greater than that of the metal plated layer.

8. The elastic electric contact terminal of claim 6, wherein the copper foil is an electrolytic copper foil or rolled copper foil, and adheres to the polymer film by applying and curing liquid polymer corresponding to the polymer film thereon, or adheres to the polymer with an adhesive in-between.

9. The elastic electric contact terminal of claim 6, wherein the metal plated layer is formed by electroless plating to thereby have an increased surface roughness such that soldering strength is improved.

10. The elastic electric contact terminal of claim 1, wherein the width thereof is greater than the length thereof.

11. The elastic electric contact terminal of claim 1, wherein the electrical contact terminal is soldered to a conductive pattern of a circuit board by using solder cream and thereby electrically connects the facing electrically conductive object to the conductive pattern while maintaining elasticity thereof.

12. An elastic electric contact terminal interposed between objects and contacting the objects to form an electric passage between the objects, the elastic electric contact terminal comprising:
an elastic core provided with at least one or more channels which are recessed downwardly from the top surface thereof with a predetermined width and depth and extend in a lengthwise direction;
an electrically conductive elastic rubber coated layer adhering to an outer surface of the elastic core; and
a solderable metal foil adhering to a lower surface of the elastic rubber coated layer,
wherein both side walls of the channels elastically support the object.

13. The elastic electric contact terminal of claim 12, further comprising a support wall protruding between the channels at a height corresponding to both the walls of the channels, wherein the channels are formed in plurality.
